# DEMANDE DE BREVET EUROPEEN

(11) **EP 2 267 724 A1**
(43) Date de publication de la demande: **29.12.2010**
(21) Numéro de dépôt: 10006145.6
(22) Date de dépôt: 14.06.2010
(51) Int. Cl.: G11C 16/16, G11C 16/04, G11C 8/12

(54) **Architecture de mémoire EEPROM optimisée pour les mémoires embarquées**

(30) Priorité: 26.06.2009 FR 0903130
(71) Demandeur: STMicroelectronics Rousset SAS, 13790 Rousset (FR)
(72) Inventeur: La Rosa, Francesco, 13790 Rousset (FR)
(74) Mandataire: Marchand, André

(57) **Abrégé**

La présente invention concerne une mémoire effaçable et programmable électriquement (MEM1) comprenant des rangées de cellules mémoire (MC) pour stocker des mots de N bits chacun, des lignes de bit (BL) et des lignes de mot (WL), dans laquelle une rangée de cellules mémoire comprend un premier groupe (G1) de cellules mémoire pour stocker des mots effaçables collectivement, et au moins un second groupe (G2) de cellules mémoire pour stocker un mot effaçable individuellement.

## Description

La présente invention concerne les architectures de mémoires non volatiles. Plus particulièrement, l'invention concerne l'architecture d'une mémoire morte programmable et effaçable électriquement (EEPROM).

Les mémoires non volatiles (NVM) permettent de stocker des données même lorsqu'aucun courant n'est appliqué. Les mémoires effaçables et programmables électriquement conventionnelles sont généralement classées en deux catégories : d'une part les mémoires EEPROM, et d'autre part les mémoires Flash-EEPROM ou mémoires "Flash".

Les cellules mémoire des mémoires EEPROM conventionnelles comprennent un transistor à grille flottante et un transistor de sélection. Le transistor de sélection présente une borne de contrôle de grille connectée à une ligne de mot, une première borne de conduction connectée à une ligne de bit et une seconde borne de conduction connectée à une première borne de conduction du transistor à grille flottante. Le transistor à grille flottante présente une borne de contrôle de grille connectée à une ligne de contrôle de grille.

Les cellules mémoire des mémoires Flash conventionnelles ne comprennent qu'un transistor à grille flottante dont la grille de contrôle est connectée à une ligne de mot et dont une première borne de conduction est connectée à une ligne de bit.

Il est bien connu que les cellules mémoire EEPROM sont adaptées à la réalisation de mémoires effaçables par mot. Conventionnellement, un "mot" comprend un groupe de N cellules mémoire dont les transistors à grille flottante sont connectés à une ligne de contrôle de grille commune. La ligne de contrôle de grille est reliée à un verrou de colonne qui permet d'appliquer simultanément une tension d'effacement à toutes les bornes de contrôle de grille des transistors à grille flottante du mot. Les cellules mémoire appartenant à d'autres mots de la mémoire ont les bornes de contrôle de grille de leurs transistors à grille flottante contrôlés par d'autres lignes de contrôle de grille et verrous de colonne.

Il est également bien connu que les cellules mémoire Flash sont adaptées à la réalisation de mémoires effaçables par page, une "page" comprenant toutes les cellules mémoire d'une rangée, puisque les bornes de contrôle de grille des cellules mémoire d'une rangée sont interconnectées et reçoivent la même tension d'effacement.

Par conséquent, les mémoires EEPROM sont généralement utilisées dans des applications pour lesquelles l'effaçabilité par mot est recherchée, alors que les mémoires Flash sont généralement utilisées dans des applications pour lesquelles la haute densité est recherchée et l'effaçabilité par mot n'est pas nécessaire. Par exemple, les mémoires EEPROM sont souvent utilisées pour stocker des données d'application alors que les mémoires Flash sont utilisées pour stocker du code (des données de programme).

Une autre différence entre les mémoires EEPROM et les mémoires Flash réside dans l'agencement des données au sein d'une rangée.

Les mémoires EEPROM comprennent généralement des rangées de cellules mémoire dans lesquelles les données sont stockées d'une manière correspondant à l'architecture logique de la mémoire. Par exemple, en supposant qu'une rangée de la mémoire est conçue pour stocker M mots W₀-W_{M-1}, chacun comprenant N bits B₀-B_{N-1}, les bits B₀-B_{N-1} du mot W₀ sont stockés dans une première colonne C₀, les bits B₀-B_{N-1} du mot W₁ sont stockés dans une seconde colonne C₁, etc., et les bits B₀-B_{N-1} du mot W_{M-1} sont stockés dans la dernière colonne C_{M-1} de la mémoire.

Au contraire, dans une rangée d'une mémoire Flash, tous les bits d'un même rang appartenant à différents mots sont en général stockés dans des cellules mémoire qui sont adjacentes et appartiennent à une même colonne. Par exemple, en supposant ici encore qu'une rangée est conçue pour stocker M mots W₀-W_{M-1} et que chaque mot comprend N bit B₀-B_{N-1}, tous les bits B₀ du même rang 0 de mots W₀-W_{M-1} de la rangée sont stockés dans une première colonne C₀, tous les bits B₁ du même rang 1 de mots W₀-W_{M-1} sont stockés dans une seconde colonne C₁, etc., et tous les bits B_{N-1} du même rang N-1 de mots W₀-W_{M-1} sont stockés dans la dernière colonne C_{N-1} de la mémoire.

En résumé, une mémoire comprenant des rangées de M mots de N bits peut comprendre M colonnes de N cellules mémoire et N lignes de bit si c'est une mémoire EEPROM, et peut comprendre N colonnes de M cellules mémoire et M lignes de bit si c'est une mémoire Flash.

Cette différence d'architecture a un effet sur la connexion des lignes de bit avec les amplificateurs de lecture prévus pour lire les cellules mémoire. Quel que soit le type d'architecture de mémoire utilisée, chaque amplificateur de lecture est en général dédié à la lecture de bits ayant le même rang, et le nombre d'amplificateurs de lecture est égal au nombre de bits dans un mot.

Si une mémoire de M mots par rangée et N bits par mot est réalisée selon l'architecture EEPROM, le premier amplificateur de lecture SA₀ est connecté à une première ligne de bit BL₀ de la première colonne C₀, à une première ligne de bit BL₀ de la colonne C₁, etc., et à une première ligne de bit BL₀ de la dernière colonne C_{M-1}. De la même façon, le second amplificateur de lecture SA₁ est connecté à une seconde ligne de bit BL₁ de la colonne C₀, à une seconde ligne de bit BL₁ de la colonne C₁, etc., et à une seconde ligne de bit BL₁ de la dernière colonne C_{M-1}, etc. Le dernier amplificateur de lecture SA_{N-1} est connecté à une dernière ligne de bit BL_{N-1} de la colonne C₀, à une dernière ligne de bit BL_{N-1} de la colonne C₁, etc., et à une dernière ligne de bit BL_{N-1} de la dernière colonne C_{M-1}.

Si une telle mémoire est réalisée selon l'architecture Flash, un premier amplificateur de lecture SA₀ est connecté aux M lignes de bit adjacentes de la première colonne C₀, un second amplificateur de lecture SA₁ est connecté aux M lignes de bit adjacentes de la seconde colonne C₁, etc., et un N^{ème} amplificateur de lecture SA_{N-1} est connecté aux M lignes de bit adjacentes de la dernière colonne C_{N-1}.

Comme la connexion de l'amplificateur de lecture avec les lignes de bit est effectuée par l'intermédiaire de lignes de multiplexage, la longueur des lignes de multiplexage est en général approximativement égale à la largeur du plan mémoire dans une mémoire EEPROM alors que dans une mémoire Flash, elle est approximativement égale à la largeur d'une colonne. Or, plus une ligne de multiplexage est longue, plus la capacité parasite correspondante est importante, ce qui entraîne des temps d'accès en lecture plus longs et une consommation électrique plus élevée en raison de la valeur de la capacité et de la durée des périodes de précharge .

Enfin, puisque les bits d'un même mot sont stockés dans des cellules mémoire connectées à des lignes de bit adjacentes dans une mémoire EEPROM et sont lues simultanément par les amplificateurs de lecture, une intermodulation peut apparaître entre les lignes de bit lors d'une opération de lecture.

Par conséquent, il apparaît que les architectures Flash et les architectures EEPROM présentent des avantages et des inconvénients respectifs qui peuvent être résumés par le tableau suivant :

| **FLASH** | **EEPROM** |
|---|---|
| Les amplificateurs de lecture S₀-S_{N-1} lisent les bits B₀-B_{N-1} d'un mot au moyen de lignes de bit non adjacentes | Les amplificateurs de lecture S₀-S_{N-1} lisent les bits B₀-B_{N-1} d'un mot au moyen de lignes de bit adjacentes |
| Des lignes de multiplexage courtes interconnectent les lignes de bit et les amplificateurs de lecture | Des lignes de multiplexage longues interconnectent les lignes de bit et les amplificateurs de lecture |
| Capacité parasite plus faible | Capacité parasite plus élevée |
| Consommation électrique plus faible lors du cycle de lecture en raison d'une capacité parasite plus faible | Consommation électrique plus élevée lors du cycle de lecture en raison d'une capacité parasite plus élevée |
| Temps d'accès plus court | Temps d'accès plus long |
| Pas d'intermodulation ou faible intermodulation | Intermodulation plus importante |
| Effaçable par page | Effaçable par mot |
| Densité plus élevée (un transistor par cellule mémoire) | Densité plus faible (deux transistors par cellules mémoire) |

On appelle "mémoires embarquées" des mémoires embarquées dans un circuit intégré comprenant d'autres composants. Par exemple, un circuit intégré pour carte à puce peut comprendre un microcontrôleur, une circuiterie d'entrée/sortie et une mémoire embarquée. Dans de telles applications à mémoire embarquée, il est en général souhaité d'utiliser la mémoire embarquée à la fois pour stocker des données de programme et des données d'application, afin d'éviter d'avoir à prévoir deux mémoires différentes, l'une pour stocker des données de programme et l'autre pour stocker des données d'application. Pour cette raison, les mémoires embarquées doivent répondre à divers besoins contradictoires. Par exemple, une mémoire EEPROM embarquée conventionnelle convient au stockage de données mais offre une efficacité de consommation électrique médiocre lorsque des données sont lues, en raison de la capacité parasite des lignes de multiplexage.

Par conséquent, il peut être souhaité de prévoir une architecture de mémoire optimisée pour des applications à mémoires embarquées.

Des modes de réalisation de l'invention concernent une mémoire effaçable et programmable électriquement comprenant des rangées de cellules mémoire configurées pour stocker des mots de N bits, des lignes de bit et des lignes de mot, dans laquelle une cellule mémoire comprend un transistor de sélection présentant une borne de contrôle connectée à une ligne de mot et une borne de conduction connectée à une ligne de bit, et un transistor à grille flottante présentant une borne de contrôle de grille pour recevoir une tension d'effacement, et dans laquelle une rangée de cellules mémoire comprend un premier groupe de cellules mémoire pour stocker des mots effaçables collectivement, et au moins un second groupe de cellules mémoire pour stocker un mot effaçable individuellement.

Selon un mode de réalisation, le premier groupe de cellules mémoires comprend 2^{m} mots effaçables collectivement, m étant un nombre entier au moins égal à 3.

Selon un mode de réalisation, les cellules mémoires du premier groupe ont la borne de contrôle de grille de leurs transistors à grille flottante interconnectée ou électriquement reliée, et les cellules mémoire du second groupe ont la borne de contrôle de grille de leurs transistors à grille flottante interconnectée ou électriquement reliée et non interconnectée ou électriquement reliée au bornes de grille flottante des cellules mémoires du premier groupe.

Selon un mode de réalisation, les bornes de contrôle de grille des transistors à grille flottante des cellules mémoires du premier groupe d'une rangée sont reliées à une première ligne de contrôle de grille commune par l'intermédiaire de premiers transistors de contrôle de grille, et les bornes de contrôle de grille des transistors à grille flottante des cellules mémoire du second groupe d'une rangée sont reliées à une seconde ligne de contrôle de grille commune par des seconds transistors de contrôle de grille.

Selon un mode de réalisation, la mémoire effaçable et programmable électriquement comprend un décodeur de rangée pour piloter des lignes de mot de la mémoire, les bornes de contrôle de grille de tous les transistors à grille flottante des cellules mémoire du premier groupe d'une rangée sont connectées à une première ligne de contrôle de grille commune qui est pilotée par le décodeur de rangée, et les bornes de contrôle de grille de tous les transistors à grille flottante des cellules mémoire du second groupe d'une rangée sont connectées à une seconde ligne de contrôle de grille commune différente de la première ligne de contrôle de grille et pilotée par le décodeur de rangée.

Selon un mode de réalisation, la mémoire effaçable et programmable électriquement comprend des moyens de sélection de rangée et des moyens de contrôle d'effacement configurés pour effacer simultanément les cellules mémoires du premier groupe d'une rangée sélectionnée sans effacer les cellules mémoires du second groupe de la rangée sélectionnée, ou pour effacer simultanément les cellules mémoires du second groupe d'une rangée sélectionnée sans effacer les cellules mémoires du premier groupe de la rangée sélectionnée.

Selon un mode de réalisation, la mémoire effaçable et programmable électriquement comprend des amplificateurs de lecture pour lire les cellules mémoires, et les cellules mémoires qui stockent des bits du même rang des différents mots d'une rangée, quel que soit le groupe auquel elles appartiennent, sont reliées au même amplificateur de lecture par l'intermédiaire de lignes de bit adjacentes.

Selon un mode de réalisation, une rangée de cellules mémoire comprend des sous-groupes de cellules mémoire adjacentes du premier groupe, des cellules mémoire du second groupe, agencées en alternance avec les sous-groupes de cellules mémoire du premier groupe, et chaque amplificateur de lecture est relié aux cellules mémoire adjacentes d'un sous-groupe de cellules mémoire du premier groupe et à une cellule mémoire du second groupe.

Selon un mode de réalisation, la mémoire effaçable et programmable électriquement comprend un premier transistor de contrôle de grille par sous-groupe de cellules mémoire du premier groupe, et un second transistor de contrôle de grille par cellule mémoire du second groupe.

Selon un mode de réalisation, la mémoire effaçable et programmable électriquement comprend un premier transistor de contrôle de grille pour deux sous-groupes de cellules mémoire du premier groupe, et un second transistor de contrôle de grille pour deux cellules mémoire du second groupe.

Selon un mode de réalisation, chaque amplificateur de lecture est relié à des lignes de bit par l'intermédiaire de transistors de sélection de mot.

Des modes de réalisation de la présente invention concernent également un circuit intégré sur microplaquette de semi-conducteur, comprenant une mémoire effaçable et programmable électriquement selon l'invention.

Selon un mode de réalisation, le circuit intégré est configuré pour stocker des données de programme dans des cellules mémoire du premier groupe et pour stocker des données d'application dans des cellules mémoire du second groupe.

Des modes de réalisation de la présente invention concernent également un dispositif portable, comprenant un circuit intégré sur microplaquette de semi-conducteur, le circuit intégré comprenant une mémoire effaçable et programmable électriquement selon l'invention.

Des modes de réalisation d'une mémoire EEPROM selon l'invention seront exposés dans la description suivante faite à titre non limitatif en relation avec les figures jointes parmi lesquelles :
- La figure 1 illustre un premier mode de réalisation d'une mémoire selon l'invention ;
- La figure 2 illustre plus en détails une partie de la mémoire de la figure 1 ;
- La figure 3 illustre un second mode de réalisation d'une mémoire selon l'invention ;
- La figure 4 illustre un troisième mode de réalisation d'une mémoire selon l'invention ; et
- La figure 5 illustre un exemple d'application d'une mémoire selon l'invention.

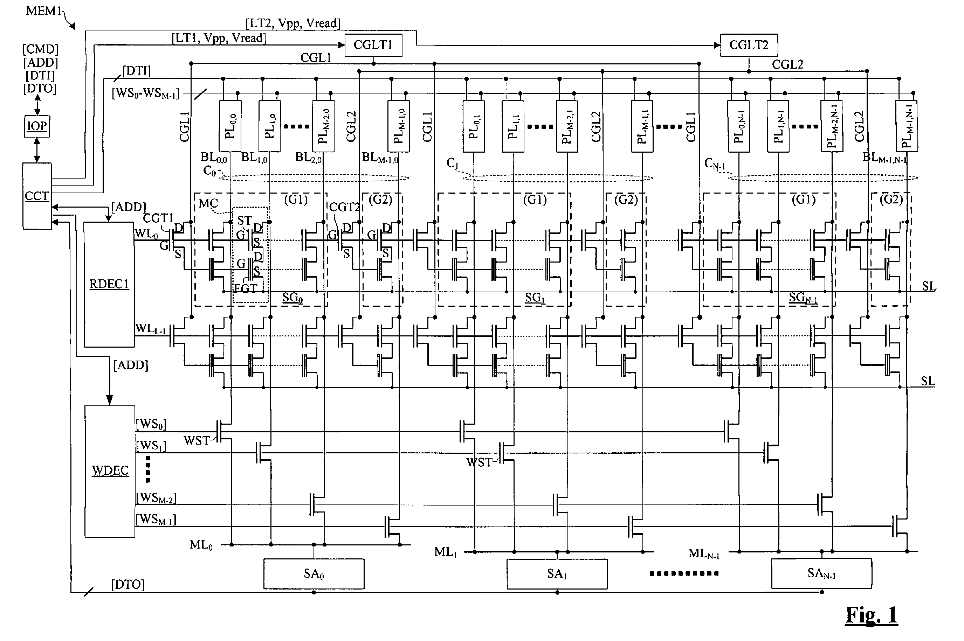

Des modes de réalisation MEM1, MEM2, MEM3 d'une mémoire selon l'invention sont respectivement illustrés sur les figures 1, 3, 4. Chaque mémoire MEM1, MEM2, MEM3 présente un plan mémoire qui comprend des cellules mémoire MC, des lignes de bit BL, et des lignes de mot WL. Chaque cellule mémoire comprend un transistor de sélection ST et un transistor à grille flottante FGT, ici du type NMOS. Le transistor de sélection ST de chaque cellule mémoire présente une borne de drain (D) connectée à une ligne de bit BL, une borne de grille (G) connectée à une ligne de mot WL, et une borne de source (S) connectée à une borne de drain (D) du transistor à grille flottante FGT de la cellule mémoire. Chaque transistor à grille flottante présente une borne de source (S) connectée à une ligne de source SL.

Les mémoires MEM1 et MEM3 comprennent en outre des transistors de contrôle de grille CGT. Le transistor à grille flottante de chaque cellule mémoire présente une borne de contrôle de grille (G) connectée à une borne de source (S) d'un transistor de contrôle de grille CGT. Le transistor de contrôle de grille CGT présente une borne de contrôle de grille (G) connectée à la même ligne de mot WL que les transistors de sélection ST des cellules mémoire auxquelles il est connecté.

L'effacement, la programmation et la lecture des cellules mémoire MC sont effectués au moyen d'un décodeur de rangée RDEC1 (MEM1, MEM3) ou RDEC2 (MEM2), d'un décodeur de mot WDEC, de verrous de programmation PL, d'amplificateurs de lecture SA et de verrous de contrôle de grille CGLT (MEM1, MEM3). Les lignes de multiplexage ML# (ML₀, ML₁,...ML_{N-1}) sont prévues pour connecter l'entrée de chaque amplificateur de lecture SA# aux lignes de bit correspondantes. Un circuit de contrôle CCT comprenant des circuits tampon et des générateurs de tension peut être prévu pour contrôler ces divers éléments et pour recevoir et exécuter des commandes d'effacement, de programmation ou de lecture CMD, y compris des adresses ADD indiquant pour quelles cellules mémoire ces commandes doivent être exécutées, et des données d'entrée DTI à stocker dans la mémoire. Dans un mode de réalisation, le circuit de contrôle CCT reçoit des commandes d'écriture accompagnées d'adresses et de données et de séquences correspondant à des opérations d'effacement et de programmation. Le circuit de contrôle CCT fournit également des données DTO qui ont été lues dans la mémoire par les amplificateurs de lecture SA. Un port d'entrée/sortie IOP peut être prévu pour recevoir de telles commandes, adresses, données d'entrée DTI de l'extérieur, et pour fournir des données de sortie DTO à l'extérieur.

Dans les exemples de réalisation illustrés sur les figures 1, 3, 4, le plan mémoire présente L lignes de mot WL₀ à WL_{L-1} et par conséquent comprend L rangées de cellules mémoire, une rangée comprenant toutes les cellules mémoire qui sont connectées à la même ligne de mot. Chaque rangée est ici prévue pour stocker M mots W₀-W_{M-1}, chacun présentant N bits B₀-B_{N-1}, par exemple 8, 16 ou 32 bits. L'architecture logique du plan mémoire est décrite dans le tableau 1 ci-dessous.

**Tableau 1**

| | | | | | |
|---|---|---|---|---|---|
| Rangée 0(WL₀) | W₀ | W₁ | ... | W_{M-2} | W_{M-1} |
| Rangée 1 (WL₁) | W₀ | W₁ | ... | W_{M-2} | W_{M-1} |
| ... | | | | | |
| Rangée L₋₁(WL_{L-1}) | W₀ | W₁ | ... | W_{M-2} | W_{M-1} |

Puisque chaque mot comprend N bits, les mémoires MEM1, MEM2, MEM3 comprennent N amplificateurs de lecture SA₀, SA₁,...SA_{N-1}. Chaque amplificateur de lecture est agencé pour lire un bit dans un mot sélectionné au moyen du décodeur de rangée RDEC1 ou RDEC2 et du décodeur de mot WDEC. Plus spécifiquement, l'amplificateur de lecture SA₀ est agencé pour lire le bit B₀ d'un mot sélectionné, l'amplificateur de lecture SA₁ est agencé pour lire le bit B₁ du mot sélectionné, etc., et l'amplificateur de lecture SA_{N-1} est agencé pour lire le bit B_{N-1} du mot sélectionné.

Selon un premier aspect de l'invention, chaque rangée comprend M-X mots qui sont simultanément effaçables et qui ne sont pas effaçables individuellement, et X mots qui sont effaçables individuellement et indépendamment des autres mots de la rangée. A cette fin, chaque rangée comprend un premier groupe G1 de cellules mémoire afin de stocker des bits B₀ à B_{N-1} des mots effaçables collectivement, et X seconds groupes G2 de cellules mémoire. Chaque second groupe G2 est prévu pour stocker des bits B₀ à B_{N-1} d'un mot effaçable individuellement. Le groupe G1 comprend donc N*(M-X) cellules mémoire et le groupe G2 comprend N*X cellules mémoire.

Dans les modes de réalisation illustrés sur les figures 1, 3, 4, seuls le mot W_{M-1} est effaçable individuellement dans chaque rangée, de telle sorte que X=1. Par conséquent, les cellules mémoire du groupe G1 sont prévues pour stocker les bits B₀ à B_{N-1} des mots W₀ à W_{M-2} et les cellules mémoire du groupe G2 sont prévues pour stocker les bits B₀ à B_{N-1} du mot V\/_{M-1}. Le groupe G1 comprend N*(M-1) cellules mémoire et le groupe G2 comprend N cellules mémoire.

Afin d'être simultanément effaçables, toutes les cellules mémoire du groupe G1 ont les grilles de contrôle de leurs transistors à grille flottante reliées ensemble ou électriquement interconnectées de manière différente dans les trois modes de réalisation MEM1, MEM2, MEM3 qui seront exposés plus en détails dans ce qui suit. De la même façon, toutes les cellules mémoire du groupe G2 ont les grilles de contrôle de leurs transistors à grille flottante reliées ensembles ou électriquement interconnectées de manière différente dans les trois modes de réalisation MEM1, MEM2, MEM3.

Les cellules mémoire du groupe G1 forment l'équivalent d'une page d'une mémoire effaçable par page, tandis que les cellules mémoire du groupe G2 forment l'équivalent d'un mot d'une mémoire effaçable par mot. En d'autres termes, les mémoires MEM1, MEM2, MEM3 peuvent être considérées comme des mémoires effaçables par page au regard des mots W₀ à W_{M-2} de chaque rangée, et comme des mémoires effaçables par mot au regard du mot W_{M-1} de chaque rangée. Dans certains modes de réalisation, le groupe G1 comprend au moins 8 mots (M-1=8), 16 mots (M-1=16) ou plus, de telle sorte que M-1 peut être écrit sous la forme 2^{m}, où m est au moins égal à 3. Dans de tels modes de réalisation, les mémoires MEM1, MEM2, MEM3 peuvent être considérées comme des mémoires effaçables par page présentant 2^{m} mots effaçables collectivement par page, et présentant au moins un mot supplémentaire effaçable individuellement dans chaque rangée.

Selon un second aspect de l'invention, les plans mémoire des mémoires MEM1, MEM2, MEM3 présentent une structure apparentée "Flash", c'est à dire que les amplificateurs de lecture SA sont reliés aux lignes de bit BL qui sont adjacentes dans le plan mémoire. Ce second aspect de l'invention est mis en oeuvre avec le premier aspect de l'invention, mais peut être mis en oeuvre indépendamment du premier aspect de l'invention dans d'autres modes de réalisation.

Il apparaît clairement dans les figures 1, 3, 4 que les lignes de multiplexage ML# sont d'une longueur réduite, réduisant ainsi la capacité parasite. Dans une mémoire EEPROM conventionnelle, et tel qu'expliqué ci-dessus, des amplificateurs de lecture sont connectés à des lignes de bit agencées dans tout le plan mémoire de telle sorte que les longueurs des lignes de multiplexage correspondent sensiblement à la largeur du plan mémoire. Un autre avantage de cet agencement des cellules mémoire est que les différents amplificateurs de lecture ne lisent pas simultanément des lignes de bit adjacentes, réduisant ainsi l'intermodulation. Par conséquent, une mémoire représentant le second aspect de l'invention fournit des temps d'accès rapides et une faible consommation en courant de lecture.

### Premier mode de réalisation

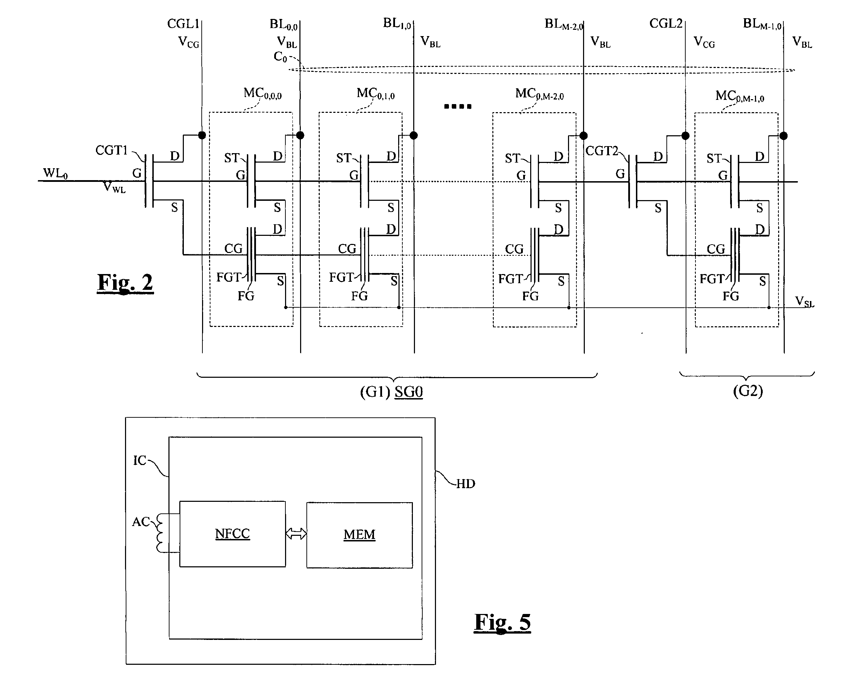

La mémoire MEM1 va maintenant être décrite plus en détails en référence avec la figure 1, ainsi que la figure 2 qui illustre une partie d'une rangée de la mémoire MEM1.

Comme indiqué précédemment, une rangée de la mémoire MEM1 comprend N*M cellules mémoire MC, parmi lesquelles N*(M-1) appartiennent au groupe G1 et N appartiennent au groupe G2. Afin de mettre en oeuvre la structure apparentée Flash, le groupe G1 est divisé en N sous-groupes SG₀, SG₁...SG_{N-1}, chacun comprenant M-1 cellules mémoire, et les cellules mémoire du groupe G2 sont agencées individuellement en alternance avec les sous-groupes SG#.

Chaque sous-groupe SG# est associé à un transistor de contrôle de grille CGT1, de telle sorte que N-1 transistors de contrôle de grille CGT1 sont prévus dans une rangée. Dans chaque sous-groupe, les bornes de contrôle de grille (G) des transistors à grille flottante sont connectées à la borne de source (S) du transistor de contrôle de grille CGT1 associé au sous-groupe. Pour permettre à toutes les cellules mémoire du groupe G1 d'être simultanément effacées, les bornes de drain (D) de tous les transistors de contrôle de grille CGT1 sont connectées à un verrou de contrôle de grille commun CGLT1 par l'intermédiaire d'une ligne de contrôle de grille commune CGL1.

De la même façon, chaque cellule mémoire du groupe G2 est associée à un transistor de contrôle de grille CGT2, de telle sorte que N-1 transistors de contrôle de grille CGT2 sont prévus dans une rangée. Pour chaque cellule mémoire du groupe G2, la borne de source (S) du transistor associé CGT2 est connectée à la grille de contrôle du transistor à grille flottante de la cellule mémoire. Pour permettre à toutes les cellules mémoire du groupe G2 d'être simultanément effacées, les bornes de drain de tous les transistors de contrôle de grille CGT2 sont connectées à un verrou de contrôle de grille commun CGLT2 par l'intermédiaire d'une ligne de contrôle de grille commune CGL2.

En résumé, chaque rangée comprend, de gauche à droite (Cf. figure 1), un transistor de contrôle de grille CGT1 connecté à M-1 cellules mémoire du groupe G1 (sous-groupe SG₀), un transistor de contrôle de grille CGT2 connecté à une cellule mémoire du groupe G2, un transistor de contrôle de grille CGT1 connecté à M-1 cellules mémoire du groupe G1 (sous-groupe SG1), un transistor de contrôle de grille CGT2 connecté à une cellule mémoire du groupe G2, etc.

Cet agencement répétitif des cellules mémoire forme N colonnes C₀ à C_{N-1} dans le plan mémoire. Chaque colonne C# comprend M lignes de bit reliées à un amplificateur de lecture correspondant SA# par l'intermédiaire de transistors de sélection de mot WST. Dans chaque rangée, chaque colonne comprend M-1 cellules mémoire d'un sous-groupe du groupe G1 et une cellule mémoire du groupe G2. Par exemple, la colonne C₀ comprend M lignes de bit BL₀,₀ à BL_{M-1,0} (BL_{W#,C#}) reliées à l'amplificateur de lecture SA₀, la colonne C1 comprend M lignes de bit reliées à l'amplificateur de lecture SA₁, etc. jusqu'à la colonne C_{N-1}, dont les M lignes de bit sont reliées à l'amplificateur de lecture SA_{N-1}.

Les cellules mémoire appartenant à la même colonne sont utilisées pour stocker des bits du même rang appartenant à différents mots W₀ à W_{M-1} de la rangée. Par exemple, et tel qu'illustré sur la figure 2, les cellules mémoire MC_{0,0,0}, MC_{0,1,0}, à MC_{0,M-2,0} (MC_{L#,W#,C#}) de la colonne C₀ dans la rangée 0 (c'est-à-dire les cellules mémoire connectées à la ligne de mot WL₀) stockent les bits B₀ des mots W₀ à W_{M-2}, qui sont simultanément effaçables, et la dernière cellule mémoire MC_{0,M-1,0} de la colonne stocke le bit B₀ du mot W_{M-1}, qui est effaçable individuellement.

Puisque les différentes lignes de bit d'une colonne C# correspondent aux bits appartenant à différents mots, les transistors de sélection de mot WST qui relient les lignes de bit de la colonne C# à l'amplificateur de lecture correspondant SA# sont pilotés par différents signaux de sélection de mot WS₀ à WS_{M-1} fournis par le décodeur de mot WDEC.

Afin d'effectuer des opérations d'effacement, de programmation ou de lecture, le décodeur de rangée RDEC1, le décodeur de mot WDEC, les verrous de programmation PL et les amplificateurs de lecture SA sont contrôlés par le circuit de contrôle CCT. Le circuit de contrôle CCT envoie au décodeur de rangée RDEC1 les bits de poids forts MSB des adresses ADD envoyées à la mémoire, envoie au décodeur de mot WDEC les bits de poids faible LSB de l'adresse ADD, et envoie aux verrous de programmation PL des bits à programmer dans la mémoire (données DTI). Les amplificateurs de lecture envoient au circuit de contrôle CCT les bits B₀-B_{N-1} d'un mot lu dans le plan mémoire (données DTO).

Les verrous de programmation PL reçoivent également les signaux de sélection de mot WS₀-WS_{M-1} fournis par le décodeur de mot WDEC, de telle sorte que seuls les verrous de programmation correspondant à une adresse de mot ADD reçue par le circuit de contrôle CCT stockent temporairement les bits à programmer dans le plan mémoire. Le circuit de contrôle CCT contrôle également les verrous de contrôle de grille CGLT1 et CGLT2, et leur fournit différentes tensions.

### Opérations d'effacement, de programmation et de lecture

Le tableau 2 ci-dessous décrit des exemples de tensions appliquées au plan mémoire lors d'opérations d'effacement, de programmation et de lecture.

**Tableau 2**

| | **VBL** | **VWL** | **VCG** | **VSL** |
|---|---|---|---|---|
| **EFFACEMENT** | HZ | Vpp | Vpp | 0 |
| **PROGRAMMATION** | Vpp | Vpp | 0 | HZ |
| **LECTURE** | V1<Vread (Ex. 1V) | V2>Vread (Ex Vread+0,8V) | Vread | 0 |

VBL est une tension appliquée aux lignes de bit sélectionnées par les verrous de programmation PL lors d'une opération de programmation, ou la tension appliquée aux lignes de bit sélectionnées par l'amplificateur de lecture SA lors d'une opération de lecture. Typiquement, Vpp est approximativement comprise entre 10 et 15 V, alors que Vcc est approximativement comprise entre 2 et 5 V. Lors des opérations d'effacement, les lignes de bit sont mises à haute impédance (HZ) puisque les verrous de programmation PL et les transistors de sélection de mot WST sont en état non passant.

VWL est une tension appliquée à une ligne de mot sélectionnée par le décodeur de rangée RDEC1 lors d'opérations d'effacement, de programmation, ou de lecture.

VCG est une tension de contrôle de grille appliquée aux bornes de contrôle de grille de toutes les cellules mémoire du groupe G1 ou G2 d'une rangée sélectionnée par les verrous de contrôle de grille CGLT1 ou CGLT2. Puisque VCG est appliquée aux cellules mémoire par l'intermédiaire des transistors de contrôle de grille CGT1 ou CGT2, seules les cellules mémoire connectées à la ligne de mot sélectionnée par le décodeur de rangée reçoivent la tension VCG car seuls les transistors de contrôle de grille CGT1 ou CGT2 de la rangée sont mis dans l'état passant par la tension VWL.

Enfin, VSL est la tension source appliquée aux bornes de source des bornes de grille flottante de toutes les cellules mémoire du plan mémoire par le circuit de contrôle CCT, ou au moins à la ligne de source correspondant à la rangée sélectionnée désignée par l'adresse ADD.

### Effacement par page

Un exemple d'opération d'effacement de page va maintenant être décrit en supposant que le circuit CCT reçoit un premier type de commande d'effacement de page avec l'adresse d'une rangée (le MSB de l'adresse ADD) qui désigne une ligne de mot, par exemple WL₀ (rangée 0). Il est supposé que le but de ce premier type de commande d'effacement de page est d'effacer les cellules mémoire du groupe G1 uniquement. Dans ce cas, les étapes suivantes sont effectuées :
- Le circuit CCT active le verrou de contrôle de grille CGLT1 à l'aide d'un signal de contrôle LT1, et lui fournit une tension d'effacement Vpp, ainsi qu'au décodeur de rangée RDEC1. Le verrou de contrôle de grille CGLT2 reste désactivé et sa sortie est mise à 0 ou HZ. Le circuit CCT met également à 0 toutes les lignes de source du plan mémoire ou au moins la ligne de source de la rangée 0, de telle sorte que les bornes de source des transistors à grille flottante de la rangée 0 sont réglées sur 0 (VSL=0) ;
- Le verrou de contrôle de grille CGLT1 applique la tension de contrôle de grille VCG à Vpp sur la ligne de contrôle de grille CGL1, de telle sorte que la tension Vpp est reçue par les bornes de drain de tous les transistors de contrôle de grille CGT1 de chaque rangée et de chaque colonne ;
- Le décodeur de rangée RDEC1 décode le MSB de l'adresse ADD et applique la tension Vpp à la ligne de mot désignée, par exemple WL₀, de telle sorte que les transistors de contrôle de grille CGT1 sont mis dans l'état passant et envoient la tension Vpp sur les bornes de contrôle de grille des transistors à grille flottante de toutes les cellules mémoire du groupe G1 connectées à la ligne de mot WL₀ (VCG=Vpp).

Par conséquent, des charges électriques sont extraites, par effet tunnel Fowler Nordheim, de la grille flottante des transistors à grille flottante du groupe G1 connectés à la ligne de mot WL₀ et les cellules mémoire sont effacées. Les cellules mémoire du groupe G2 ne sont pas effacées car la tension Vpp n'est pas fournie par le verrou de contrôle de grille CGLT2.

### Effacement de mot

Des étapes similaires sont effectuées sur les cellules mémoire du groupe G2 au lieu des cellules mémoire du groupe G1 si le circuit CCT reçoit une commande d'effacement de mot avec l'adresse d'un mot (l'adresse complète ADD). Dans ce cas, le circuit CCT active le verrou de contrôle de grille CGLT2 avec un signal de contrôle LT2, fournit au verrou CGLT2 et au décodeur de rangée RDEC1 la tension d'effacement Vpp, et règle sur 0 toutes les lignes de source du plan mémoire ou au moins la ligne de source correspondant à la rangée sélectionnée désignée par l'adresse ADD. Le décodeur de rangée applique la tension Vpp à la ligne de mot désignée par l'adresse ADD et le verrou de contrôle de grille CGLT2 applique la tension Vpp à tous les transistors de contrôle de grille CGT2, de telle sorte que toutes les cellules mémoire du groupe G2 connectées à la ligne de mot sélectionnée reçoivent la tension Vpp et sont effacées.

### Programmation

Lorsque des cellules mémoire doivent être programmées, par exemple pour stocker un mot dans une rangée 0, N verrous de programmation PL sont activés par le décodeur de mot WDEC et les bits de verrou B₀-B_{N-1} (données d'entrée DTI). Les verrous de programmation qui ont verrouillé un bit dont la valeur logique correspond à l'état programmé d'une cellule mémoire (0 ou 1, par convention) appliquent la tension Vpp (VBL=Vpp) aux lignes de bit auxquelles les cellules mémoire sont connectées. La tension Vpp est donc appliquée aux bornes de drain de tous les transistors de sélection ST connectés à cette ligne de bit. Le décodeur de rangée RDEC1 applique la tension Vpp à la ligne de mot WL₀, de telle sorte que tous les transistors de sélection ST sont mis dans l'état passant. Les transistors à grille flottante des cellules mémoire connectées aux lignes de bit activées reçoivent donc la tension Vpp. Par conséquent, des charges électriques sont injectées, par effet tunnel Fowler Nordheim, dans les grilles flottantes de ces transistors à grille flottante et les cellules mémoire sont programmées.

### Lecture

Afin de lire des cellules mémoire connectées à une ligne de mot telle qu'une ligne de mot WL₀, quel que soit le groupe G1 ou G2 auquel elles appartiennent, les verrous de contrôle de grille CGLT1 et CGLT2 appliquent simultanément la tension de lecture Vread aux lignes de contrôle de grille CGL1 et CGL2 et le décodeur de rangée applique la tension VWL à la ligne de mot WL₀ sélectionnée. Par conséquent, tous les transistors à grille flottante de la rangée reçoivent la tension Vread sur leur grille de contrôle. Simultanément, les amplificateurs de lecture SA₀-SA_{N-1} appliquent la tension VBL aux lignes de bit auxquelles les cellules mémoire à lire sont connectées, par l'intermédiaire de N transistors de sélection de mot WST qui sont mis dans l'état passant par le décodeur de mot WDEC.

### Effacement d'une page entière

En plus de la commande d'effacement de mot pour les cellules mémoire du groupe G2 et du premier type de commande d'effacement de page pour les cellules mémoire du groupe G1, un second type de commande d'effacement de page peut être prévu, visant à effacer toutes les cellules mémoire des groupes G1 et G2 dans une rangée. L'exécution d'une telle commande exige l'activation simultanée des deux verrous de contrôle de grille CGLT1, CGLT2.

### Mode de réalisation avec X mots effaçables individuellement

Comme indiqué ci-dessus, la mémoire MEM1 peut également comprendre X mots effaçables individuellement par rangée (c'est-à-dire X groupes G2). Cette variante requiert des verrous de contrôle de grille CGLT2 supplémentaires et des transistors de contrôle de grille supplémentaires par rangée et un mot effaçable individuellement supplémentaire. Dans un tel mode de réalisation, la sélection et l'activation des verrous de contrôle de grille CGLT2 pour chaque mot effaçable individuellement peuvent être contrôlées par le décodeur de mot WDEC lors d'une opération d'effacement.

### Second mode de réalisation

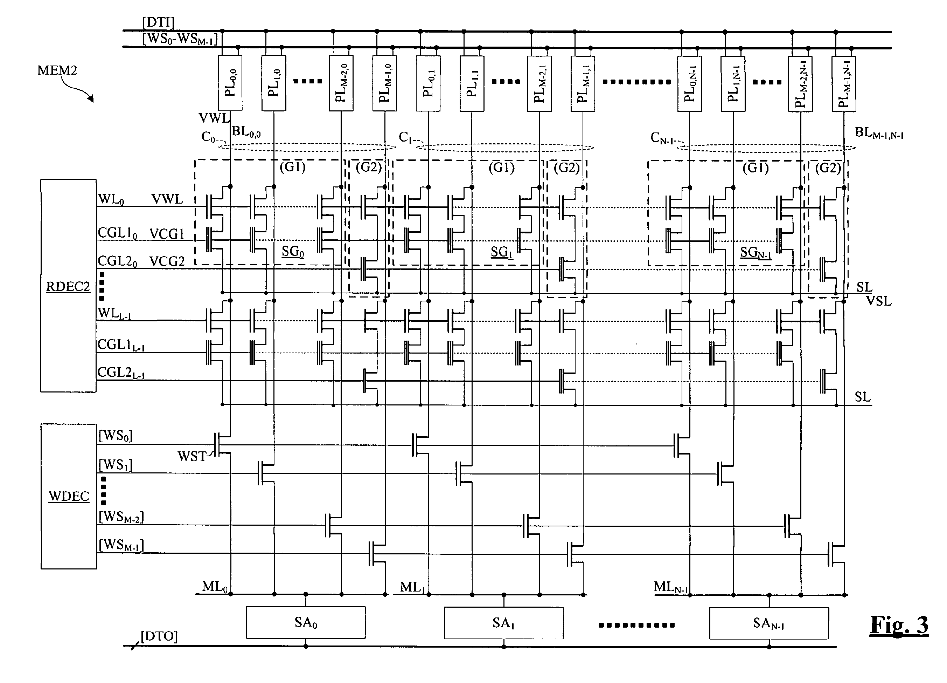

La mémoire MEM2 va maintenant être décrite plus en détails en référence avec la figure 3. La mémoire MEM2 présente un plan mémoire qui diffère de celui de la mémoire MEM1 en ce que les transistors de contrôle de grille CGT1, CGT2 et les verrous de contrôle de grille CGLT1, CGLT2 ne sont pas présents. Par conséquent, dans ce mode de réalisation chaque rangée comprend, de gauche à droite, M-1 cellules mémoire du groupe G1 (sous-groupe SG₀), une cellule mémoire du groupe G2, M-1 cellules mémoire du groupe G1 (sous-groupe SG1), une cellule mémoire du groupe G2, etc.

La mémoire MEM2 comprend un décodeur de rangée RDEC2 conçu pour contrôler séparément, dans chaque rangée, les grilles de contrôle des transistors à grille flottante de cellules mémoire du groupe G1 et, d'autre part, les grilles de contrôle des transistors à grille flottante de cellules mémoire du groupe G2.

Par conséquent, chaque rangée de rang L# comprend des lignes de contrôle de grille CGL1_{L#}, CGL2_{L#} connectées au décodeur de rangée RDEC2.La ligne de contrôle de grille CGL1_{L#} est connectée aux grilles de contrôle des transistors à grille flottante des cellules mémoire du groupe G1 alors que la ligne de contrôle de grille CGL2_{L#} est connectée aux grilles de contrôle des transistors à grille flottante des cellules mémoire du groupe G2.

Les autres éléments de la mémoire, comme le port d'entrée/sortie IOP, le circuit de contrôle CCT, le décodeur de mot WDEC, les transistors de sélection de mot WST, les verrous de programmation PL, les lignes de multiplexage ML, et les amplificateurs de lecture SA sont essentiellement les mêmes que ceux décrits précédemment en relation avec la figure 1 et sont connectés ou reliés au plan mémoire d'une façon similaire (le port d'entrée/sortie IOP et le circuit de contrôle CCT ne sont pas illustrés une nouvelle fois).

L'homme de l'art notera que les transistors de contrôle de grille CGT1, CGT2 qui ont été retirés du plan mémoire peuvent être intégrés dans le décodeur de rangée, représenté sous forme d'un bloc, dans la proportion suivante : deux transistors de contrôle de grille par rangée : un pour piloter la ligne de contrôle de grille CGL1_{L#} et l'autre pour piloter la ligne de contrôle de grille CGL2_{L#}. De la même façon, la fonction de verrouillage permettant d'appliquer des tensions aux lignes de contrôle de grille est ici effectuée par le décodeur de rangée.

Le tableau 3 ci-dessous décrit des exemples de tensions appliquées au plan mémoire lors d'opérations d'effacement, de programmation ou de lecture.

**Tableau 3**

| | **VBL** | **VWL** | **VCG1** | **VCG2** | **VSL** |
|---|---|---|---|---|---|
| **EFFACEMENT** | HZ | 0 | Vpp | Vpp | 0 |
| **PROGRAMMATION** | Vpp | Vpp | 0 | 0 | HZ |
| **LECTURE** | V1 < Vread (Ex. 1V) | V2>V1 (Ex. V1 +0,8 V) | Vread | Vread | 0 |

Les tensions VBL, VWL et VSL ont déjà été décrites. La tension VCG1 est la tension de contrôle de grille appliquée aux bornes de contrôle de grille de toutes les cellules mémoire du groupe G1 d'une rangée sélectionnée par la ligne de contrôle de grille CGL1_{L#} lors d'opérations d'effacement, de programmation ou de lecture. La tension VCG2 est une tension de contrôle de grille appliquée aux bornes de contrôle de grille de toutes les cellules mémoire du groupe G2 d'une rangée sélectionnée par la ligne de contrôle de grille CGL2_{L#} lors d'opérations d'effacement, de programmation ou de lecture. Lors de l'exécution d'une commande d'effacement de page du premier type ou de l'exécution d'une commande d'effacement de mot, VCG1 est égale à Vpp et VCG2 est réglée sur impédance élevée ou sur 0, ou vice-versa. Les tensions VCG1 et VCG2 sont toutes deux réglées sur Vpp pour l'exécution d'un second type de commande d'effacement de page (effacement de page entière), visant à effacer toutes les cellules mémoire des groupes G1 et G2 dans une rangée.

Comme indiqué ci-dessus, la mémoire MEM2 peut également comprendre X mots effaçables individuellement par rangée (c'est-à-dire X groupes G2). Cette variante requiert une ligne de contrôle de grille CGL2 supplémentaire par rangée et un mot effaçable individuellement supplémentaire.

### Troisième mode de réalisation

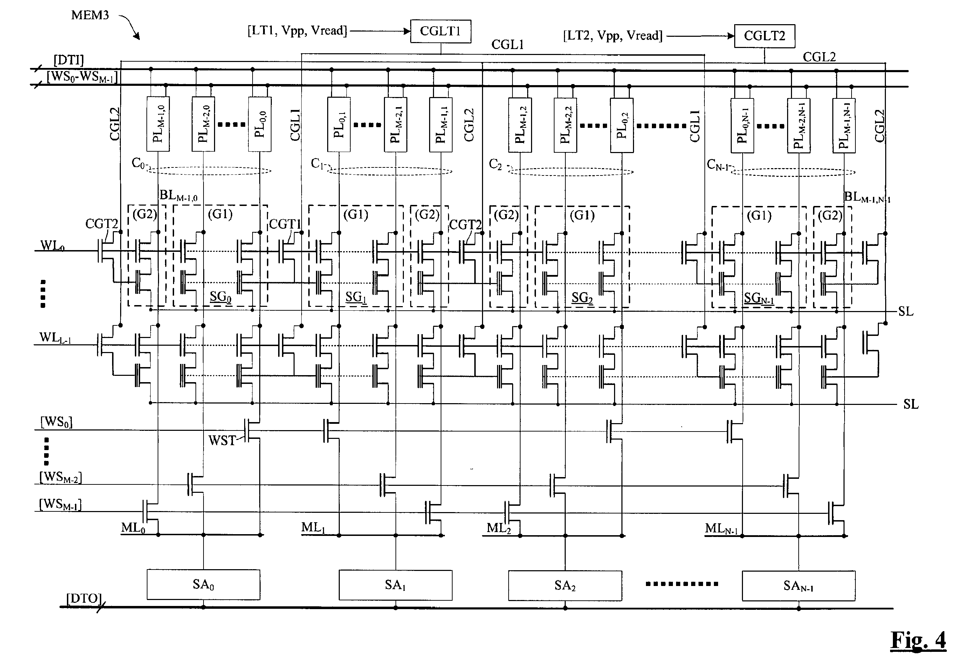

Par référence avec la figure 4, la mémoire MEM3 diffère de la mémoire MEM1 en ce que son plan mémoire présente une structure retournée. Deux autres sous-groupes SGᵢ, SGᵢ₊₁, par exemple SG₀ et SG₁, sont agencés côte à côte et partagent un transistor de contrôle de grille CGT1 commun qui est agencé entre eux et qui est connecté aux deux grilles de contrôle des transistors à grille flottante des cellules mémoire du premier sous-groupe SGᵢ, par exemple SG₀, et aux grilles de contrôle des transistors à grille flottante des cellules mémoire du second sous-groupe SGᵢ₊₁, par exemple SG₁. De la même façon, deux cellules mémoire successives du groupe G2 sont agencées côte à côte et partagent un transistor de contrôle de grille CGT2 commun qui est agencé entre elles et qui est connecté aux grilles de contrôle des transistors à grille flottante des deux cellules mémoire, à l'exception de la première et de la dernière cellule mémoire du groupe G2. Par conséquent, l'architecture d'une ligne de mot est du type G2, G1-G1, G2-G2, G1-G1, G2-G2, etc., G1-G1, G2. Le nombre de transistors de contrôle de grille CGT1, CGT2 par rangée est ainsi réduit. La première et la dernière cellule mémoire du groupe G2, correspondant aux bits B₀ et B_{N-1} du mot effaçable individuellement dans chaque ligne de mot, sont chacune individuellement connectées à un transistor de contrôle de grille CGT2.

Par conséquent, chaque rangée comprend, de gauche à droite : un transistor de contrôle de grille CGT2, une cellule mémoire du groupe G2, M-1 cellules mémoire du groupe G1, un transistor de contrôle de grille CGT1, M-1 cellules mémoire du groupe G1, une cellule mémoire du groupe G2, un transistor de contrôle de grille CGT2, une cellule mémoire du groupe G2,... un transistor de contrôle de grille CGT2, et une cellule mémoire du groupe G2.

Les autres éléments de la mémoire, comme le port d'entrée/sortie IOP, le circuit de contrôle CCT, le décodeur de rangée RDEC1, le décodeur de mot WDEC, les transistors de sélection de mot WST, les verrous de programmation PL, les lignes de multiplexage ML, et les amplificateurs de lecture SA sont essentiellement les mêmes que ceux décrits précédemment en relation avec la figure 1 et ne sont pas illustrés dans la figure 4. Les opérations d'effacement, de programmation ou de lecture sont effectuées d'une façon similaire à celle décrite ci-dessus en relation avec le tableau 1, et ne seront pas décrites à nouveau.

Il apparaîtra clairement à l'homme de l'art qu'une mémoire selon l'invention est susceptible de nombreux modes de réalisation et de nombreuses applications. Par exemple, la figure 5 illustre schématiquement un dispositif portable sans contact passif HD comprenant un circuit intégré IC, dans lequel une mémoire MEM selon l'un des modes de réalisation décrits ci-dessus est embarquée. Dans un mode de réalisation, le dispositif portable HD peut être une carte à puce sans contact, une étiquette, un téléphone portable, un PDA, etc., et présente un contrôleur de communication auquel la mémoire MEM est connectée, par exemple un contrôleur NFC NFCC (Near Field Communication) présentant une bobine d'antenne AC pour échanger des données par couplage inductif et modulation de charge, ou présentant une antenne UHF (non illustrée) pour échanger des données par couplage électrique et rétrodiffusion. Le dispositif portable est configuré pour communiquer avec un dispositif externe tel qu'une carte ou un lecteur d'étiquette sans contact, un point de vente, un autre téléphone portable NFC, etc. La mémoire MEM est utilisée à la fois pour stocker du code (en particulier des programmes d'application) et des données d'applications. Les données d'application peuvent être stockées dans le dernier mot de chaque rangée, qui est effaçable individuellement. Par conséquent, du temps est économisé lorsqu'un programme d'application doit stocker une petite quantité de données dans la mémoire. Du code peut être stocké dans les mots effaçables collectivement de la mémoire, de telle sorte que du temps est également économisé lorsque de grandes quantités de données doivent être stockées dans la mémoire, par exemple des programmes d'application récemment téléchargés. De plus, grâce à l'architecture apparentée Flash de la mémoire, il est possible d'aboutir à une faible consommation de courant lors d'opérations de lecture, de telle sorte que la distance de communication entre le dispositif portable sans contact HD et le dispositif à distance (point de vente, lecteur, etc.) est augmentée.

## Revendications

1. Mémoire effaçable et programmable électriquement (MEM, MEM1, MEM2, MEM3) comprenant :
- des rangées de cellules mémoire (MC), configurées pour stocker des mots de N-bits,
- des lignes de bits (BL) et des lignes de mots (WL),
et dans laquelle une cellule mémoire comprend :
- un transistor de sélection (ST) présentant une borne de contrôle (G) connectée à une ligne de mot et une borne de conduction (D) connectée à une ligne de bit, et
- un transistor à grille flottante (FGT) présentant une borne de contrôle de grille (G) pour recevoir une tension d'effacement (Vpp), **caractérisée en ce qu'**une rangée de cellules mémoires comprend :
- un premier groupe (G1) de cellules mémoires pour stocker des mots effaçables collectivement, et
- au moins un second groupe (G2) de cellules mémoires pour stocker un mot effaçable individuellement.

2. Mémoire effaçable et programmable électriquement selon la revendication 1, dans laquelle le premier groupe (G1) de cellules mémoires comprend 2^{m} mots effaçables collectivement, m étant un nombre entier au moins égal à 3.

3. Mémoire effaçable et programmable électriquement selon l'une des revendications 1 ou 2, dans laquelle :
- les cellules mémoires du premier groupe (G1) ont la borne de contrôle de grille (G) de leurs transistors à grille flottante (FGT) interconnectée ou électriquement reliée, et
- les cellules mémoires du second groupe (G2) ont la borne de contrôle de grille de leurs transistors à grille flottante interconnectée ou électriquement reliée et non interconnectée ou électriquement reliée aux bornes de grille flottante des cellules mémoires du premier groupe.

4. Mémoire effaçable et programmable électriquement selon l'une des revendications 1 à 3, dans laquelle :
- la borne de contrôle de grille (G) des transistors à grille flottante (FGT) des cellules mémoires (MC) du premier groupe (G1) d'une rangée est reliée à une première ligne de contrôle de grille commune (CGL1) par l'intermédiaire de premiers transistors de contrôle de grille (CGT1), et
- la borne de contrôle de grille des transistors à grille flottante des cellules mémoires du second groupe (G2) d'une rangée est reliée à une seconde ligne de contrôle de grille commune (CGL2) par l'intermédiaire de seconds transistors de contrôle de grille (CGT2).

5. Mémoire effaçable et programmable électriquement selon l'une des revendications 1 à 4, comprenant un décodeur de rangée (RDEC2) pour piloter des lignes de mot (WL) de la mémoire, et dans laquelle :
- les bornes de contrôle de grille (G) de tous les transistors à grille flottante (FGT) des cellules mémoires (MC) du premier groupe (G1) d'une rangée sont connectées à une première ligne de contrôle de grille commune (CGL1) qui est pilotée par le décodeur de rangée, et
- les bornes de contrôle de grille de tous les transistors à grille flottante des cellules mémoires du second groupe (G2) d'une rangée sont connectées à une seconde ligne de contrôle de grille commune (CGL2) différente de la première ligne de contrôle de grille et pilotée par le décodeur de rangée.

6. Mémoire effaçable et programmable électriquement selon l'une des revendications 1 à 5, comprenant des moyens de sélection de rangée (RDEC1, RDEC2) et des moyens de contrôle d'effacement (CGLT1, CGLT2, RDEC2) configurés pour effacer simultanément les cellules mémoires (MC) du premier groupe (G1) d'une rangée sélectionnée sans effacer les cellules mémoires du second groupe (G2) de la rangée sélectionnée, ou pour effacer simultanément les cellules mémoires du second groupe d'une rangée sélectionnée sans effacer les cellules mémoires du premier groupe de la rangée sélectionnée.

7. Mémoire effaçable et programmable électriquement selon l'une des revendications 1 à 6, comprenant des amplificateurs de lecture (SA) pour lire les cellules mémoires (MC), dans laquelle les cellules mémoires qui stockent des bits du même rang des différents mots d'une rangée, quel que soit le groupe auquel elles appartiennent, sont reliées au même amplificateur de lecture par l'intermédiaire de lignes de bit adjacentes (BL).

8. Mémoire effaçable et programmable électriquement selon la revendication 7, dans laquelle :
- une rangée de cellules mémoires (MC) comprend :
- des sous-groupes (SG) de cellules mémoires adjacentes du premier groupe (G1),
- des cellules mémoires du second groupe (G2), agencées en alternance avec les sous-groupes de cellules mémoires du premier groupe, et dans laquelle
- chaque amplificateur de lecture (SA) est relié aux cellules mémoires adjacentes d'un sous-groupe de cellules mémoires du premier groupe et à une cellule mémoire du second groupe.

9. Mémoire effaçable et programmable électriquement selon la revendication 8, comprenant :
- un premier transistor de contrôle de grille (CGT1) par sous-groupe (SG) de cellules mémoires (MC) du premier groupe (G1), et
- un second transistor de contrôle de grille (CGT2) par cellule mémoire du second groupe (G2).

10. Mémoire effaçable et programmable électriquement selon la revendication 8, comprenant :
- un premier transistor de contrôle de grille (CGT1) pour deux sous-groupes (SG) de cellules mémoires (MC) du premier groupe (G1), et
- un second transistor de contrôle de grille (CGT2) pour deux cellules mémoire du second groupe (G2).

11. Mémoire effaçable et programmable électriquement selon l'une des revendications 7 à 10, dans laquelle chaque amplificateur de lecture (SA) est relié à des lignes de bit par l'intermédiaire de transistors de sélection de mot (WST).

12. Circuit intégré (IC) sur une microplaquette de semi-conducteur, **caractérisé en ce qu'**il comprend une mémoire effaçable et programmable électriquement (MEM, MEM1, MEM2, MEM3) selon l'une des revendications 1 à 11.

13. Circuit intégré selon la revendication 12, configuré pour stocker des données de programme dans des cellules mémoire (MC) du premier groupe (G1) et pour stocker des données d'application dans des cellules mémoire du second groupe (G2).

14. Dispositif portable (HD), **caractérisé en ce qu'**il comprend un circuit intégré (IC) selon l'une des revendications 12 ou 13.
